# EUROPEAN PATENT SPECIFICATION

(11) **EP 4 187 437 B1**
(45) Date of publication and mention of the grant of the patent: **02.09.2026**
(21) Application number: 21846057.4
(22) Date of filing: 22.07.2021
(51) Int. Cl.: G01S 7/481, G01S 17/08, H04M 1/02

(54) **DISPLAY ASSEMBLY AND DISPLAY DEVICE**
ANZEIGEANORDNUNG UND ANZEIGEVORRICHTUNG
ENSEMBLE D'AFFICHAGE ET DISPOSITIF D'AFFICHAGE

(30) Priority: 23.07.2020 CN 202010718348
(43) Date of publication of application: 31.05.2023
(73) Proprietor: Vivo Mobile Communication Co., Ltd., Dongguan, Guangdong 523863 (CN)
(72) Inventor: CHENG, Tong, Dongguan, Guangdong 523863 (CN); LIN, Huaxin, Dongguan, Guangdong 523863 (CN)
(74) Representative: Murgitroyd & Company
(86) International application number: PCT/CN2021/107765
(87) International publication number: WO 2022/017438

(56) References cited:
- CN-A- 109 074 495
- CN-A- 109 154 959
- CN-A- 109 862 160
- CN-A- 110 520 863
- CN-A- 110 619 305
- CN-A- 110 691 153
- CN-A- 110 994 353
- CN-A- 111 052 138
- CN-A- 111 052 138
- CN-A- 111 316 287
- CN-A- 111 739 428
- CN-A- 111 768 711
- CN-U- 210 093 396
- CN-U- 210 155 472
- CN-U- 210 295 114
- US-A1- 2020 275 000

## Description

### TECHNICAL FIELD

This application relates to the field of communication technologies, and specifically, to a display assembly and a display device.

### BACKGROUND

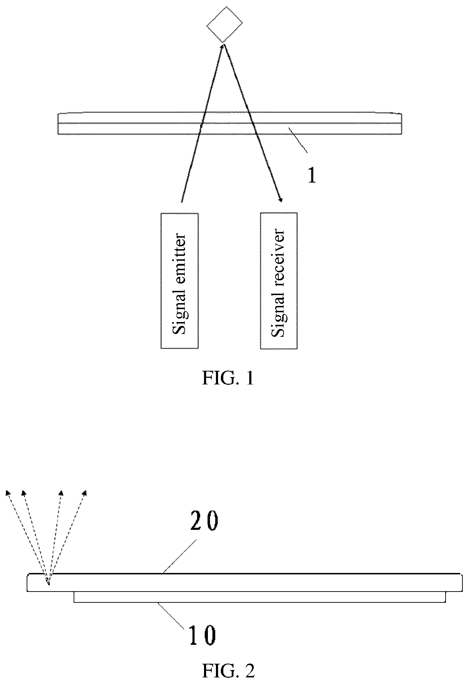

With the development of mobile intelligent terminals, the three-dimensional (three dimensional, 3D) sensing technology gradually becomes a standard hardware configuration of smartphones. Time of flight (Time of flight, TOF) is widely applied. In smartphones, the TOF is applied to physical ranging, 3D modeling, photographing performance improvement, and the like. Currently, as shown in FIG. 1, when under-screen TOF design is adopted, a laser signal emitted by a signal emitter passes through a display 1 twice before being received by a signal receiver. The transmittance of the display 1 has great impact on TOF imaging. A laser signal of a TOF detection target passes through a display twice, and experiences two significant attenuations, which leads to extremely low utilization of laser energy. Due to the high energy of the TOF laser, when an infrared laser illuminates a display region of the display from the rear side, an organic light-emitting material of display pixels in the illuminated region ages severely. As a result, the display effect of the illuminated region has an obvious color difference, which leads to serious quality problems.

D1 (CN 210093396U) discloses an under-screen 3D camera module and an electronic device. The under-screen 3D camera module comprises a depth camera module; the depth camera module comprises an edge emitting laser and an imaging module; wherein the edge emitting laser is used for emitting laser, so that the laser irradiates an object to be photographed; the imaging module is used for receiving the laser reflected by the to-be-photographed object and obtaining a depth image of the surface of the to-be-photographed object according to the laser.

D2 (CN 111052138A) discloses an optical fingerprint identification method and device and electronic equipment. The optical fingerprint identification device includes an optical path guide structure and an optical fingerprint sensor; the optical path guide structure is arranged between a display screen and the optical fingerprint sensor so as to guide a return optical signal formed by a finger above the display screen to the optical fingerprint sensor; an induction array included in the optical fingerprint sensor is used for receiving the return light signal and detecting a fingerprint image of the finger according to the return light signal. A first return optical signal included in the return light is a first optical signal that is transmitted into the finger, then transmitted out from the finger and passes through the display screen.

D3 (CN 110619305A) discloses a display screen assembly. The display screen assembly includes: a display screen that includes a liquid crystal panel and a backlight module stacked on the inner surface of the liquid crystal panel. The liquid crystal panel includes a display area and a non-display area, and a fingerprint detection area is arranged on the display area of the liquid crystal panel; a fingerprint module that is arranged on the inner surface of the non-display area of the display screen. The orthographic projection of the fingerprint module on the inner surface and the orthographic projection of a backlight module on the inner surface are staggered, and the fingerprint module is used for receiving a detection signal reflected and returned by a finger from the fingerprint detection area and generating fingerprint information according to the received detection signal.

D4 (CN 110994353A) discloses a light beam shaping module and an optical device. The light beam shaping module includes a planar optical waveguide and a shaping light unit which are sequentially arranged in the light path direction, a laser beam emitted by a laser is coupled into the planar optical waveguide, the planar optical waveguide acts in the single direction of the laser beam, and the laser beam is emitted through the shaping light unit. The planar optical waveguide directly carries out optical processing on a laser beam emitted by the laser.

### SUMMARY

An objective of embodiments of this application is to provide a display assembly and a display device to resolve the problems that a laser signal loss is serious, laser utilization is low, and an organic light-emitting material in an illuminated region is prone to damage when under-screen TOF design is adopted.

To resolve the foregoing technical problems, this application is implemented as follows:
According to a first aspect, an embodiment of this application provides a display assembly, which is defined in claim 1.

According to a second aspect, an embodiment of this application provides a display device, which is defined in claim 7.

Further advantageous embodiments of the present disclosure are indicated in the dependent claims.

It is to be understood that both the foregoing general description and the following detailed description are exemplary only, and are not restrictive of the present disclosure.

### BRIEF DESCRIPTION OF THE DRAWINGS

FIG. 1 is a transmission path of a laser signal in existing design.
FIG. 2 is a schematic diagram of a region of light emission according to an embodiment of this application.
FIG. 3 is a schematic structural diagram of a display assembly according to an embodiment of this application.
FIG. 4 is another schematic structural diagram of a display assembly according to an embodiment of this application.
FIG. 5 is a schematic diagram of a working process according to an embodiment of this application.
FIG. 6 is a schematic diagram of a VCSEL chip according to an embodiment of this application.

### Reference numerals in the drawings

Display panel 10;
Cover plate 20;
Diverging element 30;
Receiving module 40;
Light source 50; Light collimator 51; First prism 52; Second prism 53;
Housing structure 54; Rhombic prism 55;
Frame body 60;
Base plate 70; Chip 71; Glass substrate 72; Optical structure 73;
Detection target 80.

### DETAILED DESCRIPTION

The following clearly and completely describes the technical solutions in the embodiments in this application with reference to the accompanying drawings in the embodiments of this application.

Terms "first", "second", and the like in the specification and claims of this application are used to distinguish similar objects, but are not used to describe a specific sequence or order. It should be understood that the data so used may be interchanged in an appropriate condition, so that the embodiments of this application can be implemented in an order other than those illustrated or described herein. In addition, in this specification and the claims, "and/or" represents at least one of the connected objects, and the character "/" generally indicates an "or" relationship between the associated objects.

A display assembly provided in the embodiments of this application is described in detail below with reference to the accompanying drawings by using specific embodiments and application scenarios thereof.

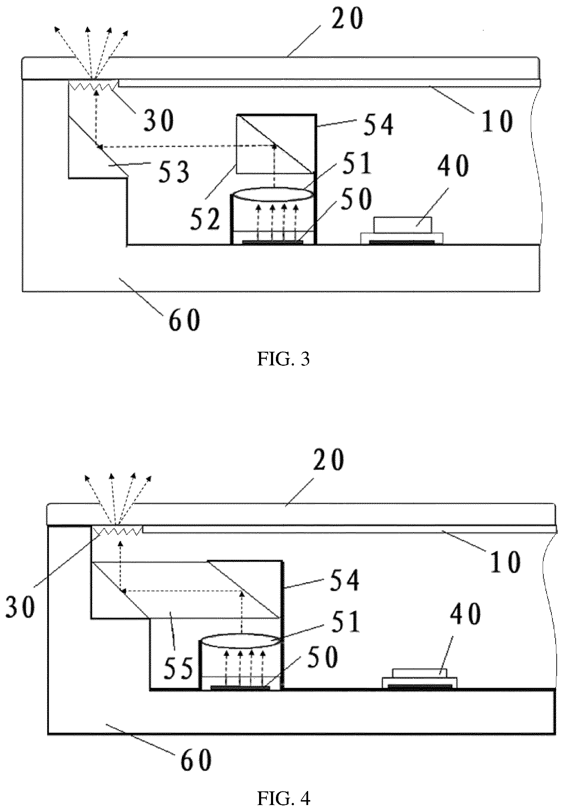

As shown in FIG. 3 and FIG. 4, according to an embodiment of this application, the display assembly includes a display panel 10, a cover plate 20, a diverging element 30, an emission module, and a receiving module 40. The cover plate 20 is disposed on a display side of the display panel 10. The diverging element 30 is located on a side of the cover plate 20 close to the display panel 10. The diverging element 30 is disposed in a non-display region of the cover plate 20 and is configured to diverge received light and emit diverged light. The emission module is configured to emit the light. The emission module is disposed on a non-display side of the display panel 10 and faces the diverging element 30. The receiving module 40 is disposed on the non-display side of the display panel 10 and is configured to receive reflected light that is formed by a detection target through reflecting light diverged by the diverging element 30.

In other words, the display assembly mainly includes the display panel 10, the cover plate 20, the diverging element 30, the emission module, and the receiving module 40. The cover plate 20 may be a member made of a transparent material, such as a glass plate, and may be disposed on the display side of the display panel 10. The display panel 10 may be protected by the cover plate 20. The diverging element 30 may diverge light incident on the diverging element 30, so that light transmitted from the diverging element 30 has a large angle and can illuminate a large region. The diverging element 30 may be located on the side of the cover plate 20 close to the display panel 10. The diverging element 30 and the display panel 10 are located on the same side of the cover plate 20. The diverging element 30 is disposed on the non-display region of the cover plate 20 and is configured to diverge received light and emit diverged light. The non-display region is a region of the cover plate 20 that is not covered by the display panel 10, that is, the diverging element 30 is disposed on the region of the cover plate 20 that is not covered by the display panel 10. For example, as shown in FIG. 2, the diverging element 30 may be disposed on a non-display region on the top or a side of the cover plate 20, so that the light can exit from the non-display region on the top or the side of the cover plate 20.

The emission module may be configured to emit light, and the light emitted by the transmission module may be transmitted to the diverging element 30. The emission module is disposed on the non-display side of the display panel 10 and faces the diverging element 30. The emission module emits light to the diverging element 30. The diverging element 30 may diverge the light after receiving the light emitted by the emission module. The receiving module 40 is disposed on the non-display side of the display panel 10, and may be configured to receive reflected light that is formed by a detection target through reflecting light diverged by the diverging element 30. The receiving module 40 may include a module lens and a module image sensor, and may receive a light signal through the module lens and the module image sensor. The display assembly may further include a processing module, and the light signal is processed by the processing module. When the detection target is close to a side of the cover plate away from the display panel 10, the detection target starts to reflect light after entering a region of light diverged by the diverging element 30. The receiving module 40 may receive light reflected by the detection target, to perform identification and analysis and make decisions according to the received reflected light. In the display assembly of this application, the light emitted by the emission module to the diverging element is diverged by the diverging element to form a light region with a large angle. Light is diverged from the non-display region of cover plate 20 and does not pass through the display panel 10 during emission. In this way, a light signal loss is reduced and light utilization is increased. The damage to the organic light-emitting material when the light illuminates the display region is reduced, and the color difference in the display effect of the illuminated region is reduced, thereby avoiding serious quality problems and punching on the display panel.

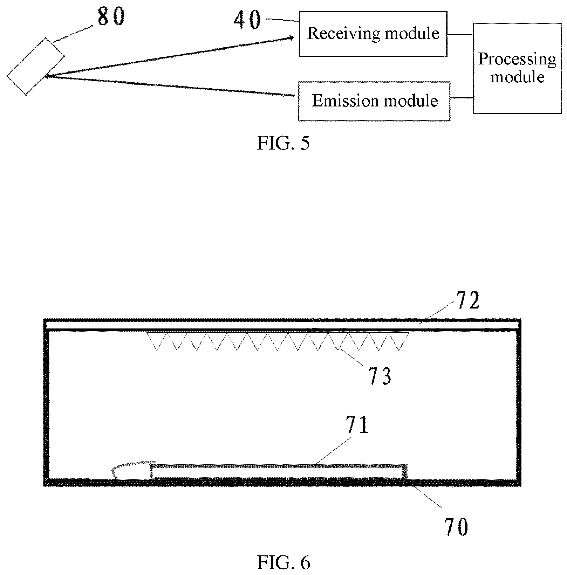

In an application process, as shown in FIG. 5, the emission module emits modulated light, such as near-infrared light. The light is reflected after encountering the detection target 80, and the receiving module 40 may receive light reflected by the detection target. The processing module calculates a time difference or phase difference between emission and reflection of the light to infer a distance of a photographed object, so as to generate depth information. Moreover, the object may be photographed by using a camera, to present three-dimensional contours of the object in a form of a topographic map with different colors representing different distances.

In some embodiments of this application, the cover plate 20 may be provided with an optical adhesive layer in a region corresponding to the diverging element 30, where the optical adhesive layer may be a transparent optical adhesive layer. The diverging element 30 may be glued on the cover plate 20 by the optical adhesive layer for ease of installing the diverging element 30. The diverging element 30 may also be glued on the cover plate 20 by other highly-transparent glue with high transmittance for the light emitted by the emission module. The light emitted by the emission module can pass through the optical adhesive layer, thereby avoiding a light loss caused by the optical adhesive layer. Alternatively, the diverging element 30 may be integrated with the cover plate 20 to reduce fitting processes and a quantity of devices.

In some embodiments, the emission module may include a light source 50 and an optical component. The light source 50 may be configured to emit light. The optical component may be configured to receive the light emitted by the light source 50, and may transmit the received light to the diverging element 30. After the light is diverged by the diverging element 30, the light transmitted from the diverging element 30 has a large angle and can illuminate a large region.

The emission module further includes a light collimator 51. Collimated light is transmitted from the light collimator 51 after the light emitted by the light source 50 is collimated by the light collimator 51. The light is collimated by the light collimator 51, thereby ensuring that a transmission path of the light is in a fixed region. The optical component adjusts the collimated light. For example, the optical component may adjust a transmission direction of the collimated light, or may cause the collimated light to be displaced/shifted. The optical component may transmit the adjusted light to the diverging element 30.

In some other embodiments of this application, the emission module may include a light source 50, a light collimator 51, and an optical component. The light source 50 may emit light, for example, a laser or an infrared ray. The light source 50 may be a vertical-cavity surface-emitting laser (Vertical-Cavity Surface-Emitting Laser, VCSEL) chip, or an edge emitting laser (Edge Emitting Laser, EEL) chip. The light emitted by the light source 50 may be transmitted to the light collimator 51. Collimated light may be transmitted after the light emitted by the light source 50 is adjusted by the light collimator 51. The light is collimated by the light collimator 51, thereby ensuring that the transmission path of the light is in the fixed region. The optical component may receive the collimated light from the light collimator 51 and adjust the collimated light. For example, the optical component may adjust the transmission direction of the collimated light, or may cause the collimated light to be displaced/shifted. The optical component transmits the adjusted light to the diverging element 30. The light source 50, the light collimator 51, and the optical component jointly cause the light to be transmitted to the diverging element 30. After being diverged by the diverging element 30, the light is transmitted from the non-display region of the cover plate 20 to form a light region with a large angle for ease of detecting a detection target.

As shown in FIG. 6, the VCSEL chip may include a base plate 70, and a side wall disposed on the base plate 70. The base plate 70 and the side wall may define a cavity in which a chip 71 connected to a gold wire may be disposed. A glass substrate 72 is disposed at an opening of the cavity to close the cavity. The glass substrate 72 may be provided with an optical structure 73 (such as a diffuser) on a side facing the chip 71, so that the light is diffused evenly with a large angle and the light emitted by the chip can be transmitted through the optical structure.

In some embodiments, as shown in FIG. 3, the optical component may include a first prism 52 and a second prism 53. The collimated light transmitted from the light collimator 51 is transmitted to the first prism 52, and the first prism 52 may adjust the transmission direction of the collimated light. The collimated light adjusted by the first prism 52 may be transmitted to the second prism 53, and the second prism 53 may adjust the transmission direction of the light transmitted from the first prism 52, so that the adjusted light is transmitted to the diverging element 30. The first prism 52 and the second prism 53 are used for adjusting the transmission direction of the collimated light transmitted from the light collimator 51. The light is then transmitted to the diverging element 30 and diverged by the diverging element 30, and is transmitted from the non-display region of the cover plate 20. In this way, an even light region with a large angle required for object detection is generated. Installation positions of the first prism 52, the second prism 53, the light source 50, and the light collimator 51 may be set as required. Besides, different optical structures may be added to adjust the transmission direction of the light.

Optionally, as shown in FIG. 3, the emission module may further include a housing structure 54. The light source 50, the light collimator 51, and the first prism 52 may be encapsulated in the housing structure 54. The housing structure 54 encapsulates the light source 50, the light collimator 51, and the first prism 52 together, which can achieve a good integration effect and avoid relative position movement among the light source 50, the light collimator 51, and the first prism 52. In this way, deviation of the light transmission direction is reduced, thereby ensuring the accuracy of the light transmitted from the first prism 52.

In this embodiment of this application, the emission module may further include a housing structure 54. The light source 50 and the light collimator 51 may be encapsulated in the housing structure 54. The housing structure 54 encapsulates the light source 50 and the light collimator 51 together, which can achieve a good integration effect and help ensure the accuracy of the light transmitted from the light collimator 51. The first prism 52 may be disposed on the non-display side of the display panel 10, glued to the non-display side of the display panel 10 by an optical clear adhesive, and disposed on the display panel 10.

Optionally, the display assembly may further include a frame body 60. The second prism 53 may be disposed on the frame body 60, and the cover plate 20 may be connected to the frame body 60. Alternatively, the receiving module 40 may be disposed on the frame body 60. The light source 50 and the light collimator 51 may be disposed on the frame body 60. The frame body 60 may support and fix other components in the assembly.

In some embodiments of this application, as shown in FIG. 4, the optical component may include a rhombic prism 55. The collimated light transmitted from the light collimator 51 may be transmitted to the rhombic prism 55. The rhombic prism 55 may cause the collimated light transmitted from the light collimator 51 to be displaced/shifted, so that the displaced/shifted light is transmitted to the diverging element 30. The rhombic prism 55 may adjust the displacement of the collimated light transmitted from the light collimator 51, without adjusting the transmission direction of the collimated light. In other words, the collimated light incident on the rhombic prism 55 is adjusted by the rhombic prism 55, and the light transmitted from the rhombic prism 55 is transmitted to the diverging element 30. A position relationship between the rhombic prism 55 and the light collimator 51 may be adjusted as required, so as to meet space installation requirements. The emission module may further include a housing structure 54. The light source 50 and the light collimator 51 may be encapsulated in the housing structure 54, and the rhombic prism 55 may be connected to the housing structure 54. A side of the rhombic prism 55 may be connected to the housing structure 54, and another side of the rhombic prism 55 may be connected to the frame body 60 by gluing. In this way, the rhombic prism 55 is stable and firm and does not become loose easily, thereby effectively reducing a tolerance of system assembly and ensuring the accuracy of the light.

In this embodiment of this application, the non-display region of the cover plate 20 may be coated with an ink layer, and the light emitted by the emission module may pass through the ink layer. For example, the light emitted by the emission module is an infrared ray. The infrared ray can pass through the ink layer, thereby avoiding a loss of light caused by the ink layer.

An embodiment of this application further provides a display device, including the display assembly in the foregoing embodiment. In the display device of this application, light emitted by an emission module does not pass through a display panel. In this way, a light signal loss is reduced and light utilization is increased. Damage to an organic light-emitting material when the light illuminates a display region is reduced, thereby improving a display effect and avoiding punching on the display panel.

The embodiments of this application have been described above with reference to the accompanying drawings. This application is not limited to the specific embodiments described above, and the specific embodiments described above are merely exemplary and not limitative.

## Claims

1. A display assembly, comprising:
a display panel (10);
a cover plate (20), disposed on a display side of the display panel (10);
a diverging element (30), located on a side of the cover plate (20) close to the display panel (10), wherein the diverging element (30) is disposed in a non-display region of the cover plate (20) and is configured to diverge received light and emit diverged light;
an emission module, configured to emit light, wherein the emission module is disposed on a non-display side of the display panel (10) and faces the diverging element (30); and
a receiving module (40), disposed on the non-display side of the display panel (10) and configured to receive reflected light that is formed by a detection target (80) through reflecting light diverged by the diverging element (30); wherein
the emission module comprises:
a light source (50), configured to emit light; and
an optical component, configured to receive the light emitted by the light source (50) and transmit the received light to the diverging element (30); **characterized in that**
the emission module further comprises:
a light collimator (51), wherein collimated light is transmitted from the light collimator (51) after the light emitted by the light source (50) is collimated by the light collimator (51), and the optical component adjusts the collimated light and transmits adjusted light to the diverging element (30).

2. The display assembly according to claim 1, wherein the optical component comprises:
a first prism (52), wherein the collimated light transmitted from the light collimator (51) is transmitted to the first prism (52); and
a second prism (53), wherein the second prism (53) adjusts a transmission direction of light transmitted from the first prism (52) to cause adjusted light to be transmitted to the diverging element (30).

3. The display assembly according to claim 2, wherein the emission module further comprises:
a housing structure (54), wherein the light source (50), the light collimator (51), and the first prism (52) are encapsulated in the housing structure (54).

4. The display assembly according to claim 2, wherein the emission module further comprises:
a housing structure (54), wherein the light source (50) and the light collimator (51) are encapsulated in the housing structure (54), and the first prism (52) is disposed on the non-display side of the display panel (10).

5. The display assembly according to claim 2, further comprising:
a frame body (60), wherein the second prism (53) is disposed on the frame body (60) and the cover plate (20) is connected to the frame body (60).

6. The display assembly according to claim 1, wherein the optical component comprises:
a rhombic prism (55), wherein the collimated light transmitted from the light collimator (51) is transmitted to the rhombic prism (55), and the rhombic prism (55) causes the collimated light from the light collimator (51) to be shifted, so that shifted light is transmitted to the diverging element (30); and
the emission module further comprises a housing structure (54), wherein the light source (50) and the light collimator (51) are encapsulated in the housing structure (54) and the rhombic prism (55) is connected to the housing structure (54).

7. A display device, **characterized by** comprising the display assembly according to any one of claims 1 to 6.

## Patentansprüche

1. Eine Anzeigeanordnung, beinhaltend:
eine Anzeigetafel (10);
eine Abdeckplatte (20), die auf einer Anzeigeseite der Anzeigetafel (10) angeordnet ist;
ein Zerstreuungselement (30), das sich auf einer Seite der Abdeckplatte (20) nahe der Anzeigetafel (10) befindet, wobei das Zerstreuungselement (30) in einem Nicht-Anzeige-Bereich der Abdeckplatte (20) angeordnet ist und dazu konfiguriert ist,
empfangenes Licht zu zerstreuen und zerstreutes Licht zu emittieren;
ein Emissionsmodul, das dazu konfiguriert ist, Licht zu emittieren, wobei das Emissionsmodul auf einer Nicht-Anzeige-Seite der Anzeigetafel (10) angeordnet ist und zu dem Zerstreuungselement (30) weist; und
ein Empfangsmodul (40), das auf der Nicht-Anzeige-Seite der Anzeigetafel (10) angeordnet und dazu konfiguriert ist, reflektiertes Licht zu empfangen, das von einem Erkennungsziel (80) durch Reflektieren von Licht, das von dem Zerstreuungselement (30) zerstreut wurde, gebildet wird; wobei
das Emissionsmodul Folgendes beinhaltet:
eine Lichtquelle (50), die dazu konfiguriert ist, Licht zu emittieren; und
eine optische Komponente, die dazu konfiguriert ist, das von der Lichtquelle (50) emittierte Licht zu empfangen und das empfangene Licht an das Zerstreuungselement (30) zu übertragen; **dadurch gekennzeichnet, dass**
das Emissionsmodul ferner Folgendes beinhaltet:
einen Lichtkollimator (51), wobei kollimiertes Licht von dem Lichtkollimator (51) übertragen wird, nachdem das von der Lichtquelle (50) emittierte Licht durch den Lichtkollimator (51) kollimiert wurde, und die optische Komponente das kollimierte Licht anpasst und angepasstes Licht an das Zerstreuungselement (30) überträgt.

2. Anzeigeanordnung gemäß Anspruch 1, wobei die optische Komponente Folgendes beinhaltet:
ein erstes Prisma (52), wobei das von dem Lichtkollimator (51) übertragene kollimierte Licht an das erste Prisma (52) übertragen wird; und
ein zweites Prisma (53), wobei das zweite Prisma (53) eine Übertragungsrichtung von Licht, das von dem ersten Prisma (52) übertragen wird, anpasst, sodass es bewirkt, dass angepasstes Licht an das Zerstreuungselement (30) übertragen wird.

3. Anzeigeanordnung gemäß Anspruch 2, wobei das Emissionsmodul ferner Folgendes beinhaltet:
eine Gehäusestruktur (54), wobei die Lichtquelle (50), der Lichtkollimator (51) und das erste Prisma (52) in der Gehäusestruktur (54) eingekapselt sind.

4. Anzeigeanordnung gemäß Anspruch 2, wobei das Emissionsmodul ferner Folgendes beinhaltet:
eine Gehäusestruktur (54), wobei die Lichtquelle (50) und der Lichtkollimator (51) in der Gehäusestruktur (54) eingekapselt sind und das erste Prisma (52) auf der Nicht-Anzeige-Seite der Anzeigetafel (10) angeordnet ist.

5. Anzeigeanordnung gemäß Anspruch 2, ferner beinhaltend:
einen Rahmenkörper (60), wobei das zweite Prisma (53) auf dem Rahmenkörper (60) angeordnet ist und die Abdeckplatte (20) mit dem Rahmenkörper (60) verbunden ist.

6. Anzeigeanordnung gemäß Anspruch 1, wobei die optische Komponente Folgendes beinhaltet:
ein rhombisches Prisma (55), wobei das von dem Lichtkollimator (51) übertragene kollimierte Licht an das rhombische Prisma (55) übertragen wird und das rhombische Prisma (55) bewirkt, dass das kollimierte Licht von dem Lichtkollimator (51) verschoben wird, sodass das verschobene Licht an das Zerstreuungselement (30) übertragen wird; und
das Emissionsmodul ferner eine Gehäusestruktur (54) beinhaltet, wobei die Lichtquelle (50) und der Lichtkollimator (51) in der Gehäusestruktur (54) eingekapselt sind und das rhombische Prisma (55) mit der Gehäusestruktur (54) verbunden ist.

7. Eine Anzeigevorrichtung, die **dadurch gekennzeichnet ist, dass** sie die Anzeigeanordnung gemäß einem der Ansprüche 1 bis 6 beinhaltet.

## Revendications

1. Un ensemble d'affichage, comprenant :
un panneau d'affichage (10) ;
une plaque de recouvrement (20), disposée sur un côté d'affichage du panneau d'affichage (10) ;
un élément de divergence (30), situé sur un côté de la plaque de recouvrement (20) proche du panneau d'affichage (10), l'élément de divergence (30) étant disposé dans une région de non-affichage de la plaque de recouvrement (20) et étant configuré pour faire diverger de la lumière reçue et émettre de la lumière divergée ;
un module d'émission, configuré pour émettre de la lumière, le module d'émission étant disposé sur un côté de non-affichage du panneau d'affichage (10) et faisant face à l'élément de divergence (30) ; et
un module de réception (40), disposé sur le côté de non-affichage du panneau d'affichage (10) et configuré pour recevoir de la lumière réfléchie qui est formée par une cible de détection (80) par la réflexion de lumière divergée par l'élément de divergence (30) ; dans lequel
le module d'émission comprend :
une source de lumière (50), configurée pour émettre de la lumière ; et
un composant optique, configuré pour recevoir la lumière émise par la source de lumière (50) et transmettre la lumière reçue à l'élément de divergence (30) ; **caractérisé en ce que**
le module d'émission comprend en outre :
un collimateur de lumière (51), de la lumière collimatée étant transmise à partir du collimateur de lumière (51) après que la lumière émise par la source de lumière (50) a été collimatée par le collimateur de lumière (51), et le composant optique réglant la lumière collimatée et transmettant de la lumière réglée à l'élément de divergence (30).

2. L'ensemble d'affichage selon la revendication 1, dans lequel le composant optique comprend :
un premier prisme (52), la lumière collimatée transmise à partir du collimateur de lumière (51) étant transmise au premier prisme (52) ; et
un deuxième prisme (53), le deuxième prisme (53) réglant une direction de transmission de lumière transmise à partir du premier prisme (52) pour amener de la lumière réglée à être transmise à l'élément de divergence (30).

3. L'ensemble d'affichage selon la revendication 2, dans lequel le module d'émission comprend en outre :
une structure de boîtier (54), la source de lumière (50), le collimateur de lumière (51), et
le premier prisme (52) étant encapsulés dans la structure de boîtier (54).

4. L'ensemble d'affichage selon la revendication 2, dans lequel le module d'émission comprend en outre :
une structure de boîtier (54), la source de lumière (50) et le collimateur de lumière (51) étant encapsulés dans la structure de boîtier (54), et le premier prisme (52) étant disposé sur le côté de non-affichage du panneau d'affichage (10).

5. L'ensemble d'affichage selon la revendication 2, comprenant en outre :
un corps formant châssis (60), le deuxième prisme (53) étant disposé sur le corps formant châssis (60) et la plaque de recouvrement (20) étant reliée au corps formant châssis (60).

6. L'ensemble d'affichage selon la revendication 1, dans lequel le composant optique comprend :
un prisme rhombique (55), la lumière collimatée transmise à partir du collimateur de lumière (51) étant transmise au prisme rhombique (55), et le prisme rhombique (55) amenant la lumière collimatée provenant du collimateur de lumière (51) à être décalée, de sorte que de la lumière décalée est transmise à l'élément de divergence (30) ; et
le module d'émission comprend en outre une structure de boîtier (54), la source de lumière (50) et le collimateur de lumière (51) étant encapsulés dans la structure de boîtier (54) et le prisme rhombique (55) étant relié à la structure de boîtier (54).

7. Un dispositif d'affichage, **caractérisé en ce qu'**il comprend l'ensemble d'affichage selon l'une quelconque des revendications 1 à 6.
